# EUROPEAN PATENT APPLICATION

(11) **EP 4 815 303 A1**
(43) Date of publication of application: **30.09.2026**
(21) Application number: 25220970.5
(22) Date of filing: 05.12.2025
(51) Int. Cl.: H03K 3/017, G11C 7/22, H03K 5/156

(54) **DUTY CYCLE CORRECTION CIRCUIT**

(30) Priority: 28.03.2025 KR 20250040207
(71) Applicant: SK hynix Inc., Bubal-eub Icheon-si Gyeonggi-do 17336 (KR)
(72) Inventor: LEE, Ji Young, 17336 Icheon-si, Gyeonggi-do (KR); KWON, Do Hyeon, 17336 Icheon-si, Gyeonggi-do (KR); KIM, Heon Ki, 17336 Icheon-si, Gyeonggi-do (KR); RYU, Chan Yang, 17336 Icheon-si, Gyeonggi-do (KR); PARK, Ji Hyeon, 17336 Icheon-si, Gyeonggi-do (KR); OK, Sung Hwa, 17336 Icheon-si, Gyeonggi-do (KR); CHOI, Eun Ji, 17336 Icheon-si, Gyeonggi-do (KR); HONG, Jae Hyeong, 17336 Icheon-si, Gyeonggi-do (KR)
(74) Representative: Isarpatent

(57) **Abstract**

A duty cycle correction circuit includes a duty adjustment circuit and a duty control circuit. The duty adjustment circuit generates a plurality of duty correction clock signals by adjusting phases of a plurality of external clock signals according to a plurality of codes. The duty control circuit controls a first correction operation of finding and fixing an optimal value of a first code among the plurality of codes and a second correction operation of finding and fixing an optimal value of a second code among the plurality of codes. The duty control circuit is configured to, in each of a plurality of cycles during which the first correction operation is performed, change the first code by a basic unit within a first adjustable range and change the second code by a maximum value within a second adjustable range.

## Description

### BACKGROUND

### 1.TECHNICAL FIELD

Various embodiments of the present disclosure generally relate to a semiconductor circuit, and, more particularly, to a duty cycle correction circuit.

### 2. RELATED ART

In semiconductor circuits that operate based on a clock signal, such as a semiconductor memory and a central processing unit (CPU) or a graphic processing unit (GPU) that controls the semiconductor memory, it is extremely important to precisely control the duty cycle of the clock signal. For example, in semiconductor memory where data is input and output at both the rising and falling edges of the clock signal, if the duty cycle is not exactly 50%, the timing between the rising and falling edges becomes skewed, preventing data from being correctly input or output at the intended timing. Here, a 50% duty cycle means that a 'high' level period and a 'low' level period of the clock signal are of equal duration. Therefore, in various semiconductor circuits operating based on clock signals, use of a duty cycle correction circuit is essential to correct the duty cycle of the clock signal. The duty cycle correction circuit includes a first delay circuit and a second delay circuit, controls the first delay circuit according to a first code, and controls the second delay circuit according to a second code. The duty cycle correction circuit performs duty cycle correction by adjusting the values of the first and second codes based on the phase difference between two signals output from the second delay circuit.

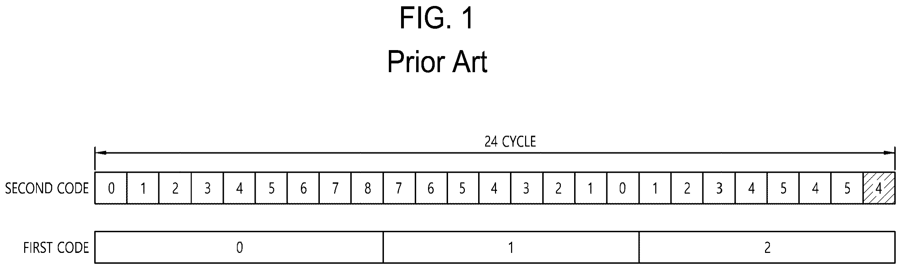

FIG. 1 illustrates an example of code variation during the duty cycle correction operation according to conventional technology. In this example, the first code is adjusted to '2' and the second code to '4', successfully adjusting the duty cycle of the clock signal to 50% within an acceptable error range. Here, '2' and '4' refer to steps rather than the values of the codes. The first code has different values for each step based on a binary code method, while the second code has different values for each step based on a Gray code method. The Gray code method increases or decreases the number of bits with a value of '1' (binary) or '0' (binary) by one for each step of increase or decrease.

Referring to FIG. 1, the conventional duty cycle correction circuit operates by fixing the first code at '0' and incrementing the second code step by step from '0'. When the second code reaches its maximum step of '8', the first code is incremented by one step, and the second code is decremented by one step. The duty cycle correction operation is completed by detecting a bang-bang state between the first and second codes. When the time to change the code by one step is defined as one cycle, detecting the bang-bang state of the second code, specifically the repetition of '4' and '5', takes 24 cycles. A problem with conventional technology is that the locking time, or the time taken to complete the duty cycle correction, is prolonged.

### SUMMARY

In an embodiment,a duty cycle correction circuit may include: a duty adjustment circuit configured to adjust phases of a plurality of external clock signals according to a plurality of codes to generates a plurality of duty correction clock signals; and a duty control circuit may control a first correction operation of finding and fixing an optimal value of a first code among the plurality of codes and a second correction operation of finding and fixing an optimal value of a second code among the plurality of codes. The duty control circuit is configured to, in each of a plurality of cycles during which the first correction operation is performed, change the first code by a basic unit within a first adjustable range and change the second code by a maximum value within a second adjustable range.

In an embodiment, a duty cycle correction circuit may include: a duty adjustment circuit configured to adjust phases of a plurality of external clock signals according to a plurality of codes to generate a plurality of duty correction clock signals; a duty detection circuit configured to generate a plurality of duty detection signals according to the plurality of duty correction clock signals; a code adjustment clock generation circuit configured to generate a plurality of code adjustment clock signals for varying a second code among the plurality of codes by a maximum value within an adjustable range for each of a plurality of cycles in a first section, the first section including a time frame from a time at which adjustment of a first code among the plurality of codes starts to a time at which the adjustment of the first code is completed to activate a first code adjustment completion signal; a multiplexer configured to selectively output the plurality of code adjustment clock signals and a plurality of duty detection valid signals according to the first code adjustment completion signal; a first code adjustment circuit configured to vary the first code according to the plurality of duty detection valid signals, and configured to generate a first code minimum detection signal and a first code maximum detection signal according to the first code; and a second code adjustment circuit configured to vary the second code according to an output of the multiplexer.

### BRIEF DESCRIPTION OF THE DRAWINGS

FIG. 1 is a diagram illustrating an example of code variation during a duty cycle correction operation according to conventional technology.
FIG. 2 is a diagram illustrating a configuration of a duty cycle correction circuit according to an embodiment of the present disclosure.
FIG. 3 is a diagram illustrating a detailed configuration of a first adjustment circuit of FIG. 2, according to an embodiment of the present disclosure.
FIG. 4 is a diagram illustrating a detailed configuration of a second adjustment circuit of FIG. 2, according to an embodiment of the present disclosure.
FIG. 5 is a diagram for describing a method of changing a second code, according to an embodiment of the present disclosure.
FIG. 6 is a diagram illustrating a detailed configuration of a duty control circuit of FIG. 2, according to an embodiment of the present disclosure.
FIG. 7 is a diagram illustrating a detailed configuration of a code adjustment clock generation circuit of FIG. 6, according to an embodiment of the present disclosure.
FIG. 8 is a diagram illustrating a detailed configuration of a shifting unit of FIG. 7, according to an embodiment of the present disclosure.
FIG. 9 is a timing diagram for describing an operation of the code adjustment clock generation circuit of FIG. 7, according to an embodiment of the present disclosure.
FIG. 10 is a diagram illustrating a detailed configuration of a completion determination circuit of FIG. 6, according to an embodiment of the present disclosure.
FIG. 11 is a timing diagram for describing an operation of the completion determination circuit of FIG. 10, according to an embodiment of the present disclosure.
FIG. 12 is a diagram illustrating a detailed configuration of a code value determination circuit of FIG. 6, according to an embodiment of the present disclosure.
FIGS. 13 to 18 are timing diagrams for describing a duty cycle correction operation of a duty cycle correction circuit according to an embodiment of the present disclosure.
FIG. 19 is a diagram illustrating an example of code variation during a duty cycle correction operation according to an embodiment of the present disclosure.

### DETAILED DESCRIPTION

Various embodiments of the present disclosure may reduce the time required for duty cycle correction, thereby securing timing margins and increasing the resolution of duty cycle correction.

Hereinafter, embodiments of the present disclosure will be described in more detail with reference to the accompanying drawings.

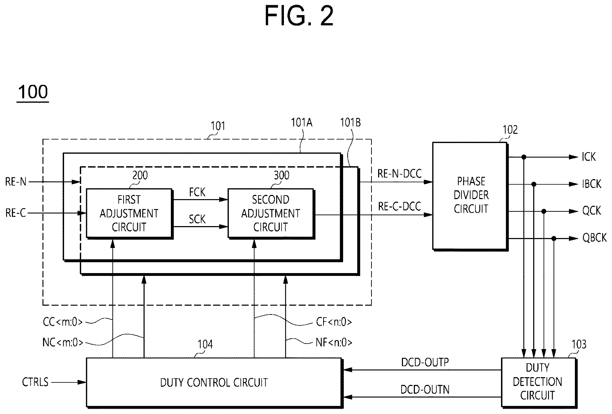

FIG. 2 is a diagram illustrating a configuration of a duty cycle correction circuit 100 according to an embodiment of the present disclosure.

Referring to FIG. 2, the duty cycle correction circuit 100 may include a duty adjustment circuit 101, a phase divider circuit 102, a duty detection circuit 103, and a duty control circuit 104.

The duty adjustment circuit 101 may receive a plurality of external clock signals RE-C and RE-N and a plurality of codes CC<m:0>, CF<n:0>, NC<m:0>, and NF<n:0>, and may output a plurality of duty correction clock signals RE-C-DCC and RE-N-DCC. The duty adjustment circuit 101 may include a first duty adjustment circuit 101A and a second duty adjustment circuit 101B.

The plurality of external clock signals RE-C and RE-N may include a first external clock signal RE-C and a second external clock signal RE-N.

The plurality of codes CC<m:0>, CF<n:0>, NC<m:0>, and NF<n:0> may be classified into a first code set CC<m:0> and CF<n:0> related to the phase correction of the first external clock signal RE-C, and a second code set NC<m:0> and NF<n:0> related to the phase correction of the second external clock signal RE-N, and may be selectively adjusted. In the first code set CC<m:0> and CF<n:0>, CC<m:0> is referred to as a first code, and CF<n:0> is referred to as a second code. In the second code set NC<m:0> and NF<n:0>, NC<m:0> is referred to as a third code, and NF<n:0> is referred to as a fourth code. During a duty correction operation, one of the first code set CC<m:0> and CF<n:0> and the second code set NC<m:0> and NF<n:0> may be selected according to operating conditions. Although NC<m:0> and NF<n:0> are referred to as the third code and the fourth code for distinction, if the second code set NC<m:0> and NF<n:0> is selected for phase correction of the second external clock signal RE-N, the third code NC<m:0> is used corresponding to the first code CC<m:0>, and the fourth code NF<n:0> is used corresponding to the second code CF<n:0>.

The first code CC<m:0> and the second code CF<n:0> may be used for phase adjustment of the first duty adjustment circuit 101A. The third code NC<m:0> and the fourth code NF<n:0> may be used for phase adjustment of the second duty adjustment circuit 101B. The plurality of duty correction clock signals RE-C-DCC and RE-N-DCC may include a first duty correction clock signal RE-C-DCC and a second duty correction clock signal RE-N-DCC.

The first duty adjustment circuit 101A may receive the first external clock signal RE-C, the first code CC<m:0>, and the second code CF<n:0>, and may output the first duty correction clock signal RE-C-DCC.

The second duty adjustment circuit 101B may receive the second external clock signal RE-N, the third code NC<m:0>, and the fourth code NF<n:0>, and may output the second duty correction clock signal RE-N-DCC.

The first duty adjustment circuit 101A may include a first adjustment circuit 200 and a second adjustment circuit 300. The first adjustment circuit 200 may delay the first external clock signal RE-C by a time corresponding to the first code CC<m:0> to generate a first clock signal FCK and a second clock signal SCK. The second adjustment circuit 300 may mix the first clock signal FCK and the second clock signal SCK at a predetermined ratio according to the second code CF<n:0> to generate the first duty correction clock signal RE-C-DCC. The word "predetermined" as used herein with respect to a parameter, such as a predetermined timing, time, or voltage level, means that a value for the parameter is determined prior to the parameter being used in a process or algorithm. For some embodiments, the value for the parameter is determined before the process or algorithm begins. In other embodiments, the value for the parameter is determined during the process or algorithm but not before the parameter is used in the process or algorithm.

The second duty adjustment circuit 101B may be configured similarly to the first duty adjustment circuit 101A.

The phase divider circuit 102 may receive the first duty correction clock signal RE-C-DCC and the second duty correction clock signal RE-N-DCC, and may output multi-phase clock signals ICK, IBCK, QCK, and QBCK. The phase divider circuit 102 may divide the phases of the first duty correction clock signal RE-C-DCC and the second duty correction clock signal RE-N-DCC to generate the multi-phase clock signals ICK, IBCK, QCK, and QBCK.

The duty detection circuit 103 may receive the multi-phase clock signals ICK, IBCK, QCK, and QBCK, and may output a plurality of duty detection signals DCD-OUTP and DCD-OUTN. The duty detection circuit 103 may detect the phase differences of the multi-phase clock signals ICK, IBCK, QCK, and QBCK to generate the plurality of duty detection signals DCD-OUTP and DCD-OUTN. The plurality of duty detection signals DCD-OUTP and DCD-OUTN may include a first duty detection signal DCD-OUTP and a second duty detection signal DCD-OUTN.

The duty detection circuit 103 may output a signal obtained by adding the phase difference between QCK and IBCK and the phase difference between QBCK and ICK as the first duty detection signal DCD-OUTP, and may output a signal obtained by adding the phase difference between ICK and QCK and the phase difference between IBCK and QBCK as the second duty detection signal DCD-OUTN.

The duty control circuit 104 may receive a plurality of control signals CTRLS and the plurality of duty detection signals DCD-OUTP and DCD-OUTN, and may output the plurality of codes CC<m:0>, CF<n:0>, NC<m:0>, and NF<n:0>. The plurality of control signals CTRLS may be generated, for example, by a system including the duty cycle correction circuit 100 according to an embodiment of the present disclosure, such as a semiconductor memory apparatus or a memory controller for controlling the semiconductor memory apparatus, based on an external command or an internally determined sequence, and may be provided to the duty cycle correction circuit 100.

The duty control circuit 104 may adjust the values of the plurality of codes CC<m:0>, CF<n:0>, NC<m:0>, and NF<n:0> based on the plurality of duty detection signals DCD-OUTP and DCD-OUTN.

The operation of adjusting the values of the plurality of codes CC<m:0>, CF<n:0>, NC<m:0>, and NF<n:0> according to the plurality of duty detection signals DCD-OUTP and DCD-OUTN, that is, the duty cycle correction operation, may include a first correction operation and a second correction operation. The duty cycle correction operation may be performed within a predetermined section (hereinafter, referred to as a section) according to an operating specification of a system including the duty cycle correction circuit 100. The entire section in which the duty cycle correction operation is performed may include a first section for the first correction operation and a second section for the second correction operation. The first correction operation may include finding optimal values of the first code CC<m:0> and the third code NC<m:0>. The second correction operation may include finding optimal values of the second code CF<n:0> and the fourth code NF<n:0>. Each of the first section and the second section may include a plurality of cycles.

The duty control circuit 104 may detect whether a bang-bang state occurs in the plurality of codes CC<m:0>, CF<n:0>, NC<m:0>, and NF<n:0>, and may stop adjusting the plurality of codes CC<m:0>, CF<n:0>, NC<m:0>, and NF<n:0> when the bang-bang state is detected.

The duty control circuit 104 may selectively control the first duty adjustment circuit 101A and the second duty adjustment circuit 101B. When the first duty adjustment circuit 101A is selected, the duty control circuit 104 may adjust the first code CC<m:0> and the second code CF<n:0> based on the plurality of duty detection signals DCD-OUTP and DCD-OUTN. When the second duty adjustment circuit 101B is selected, the duty control circuit 104 may adjust the third code NC<m:0> and the fourth code NF<n:0> based on the duty detection signals DCD-OUTP and DCD-OUTN.

Because the operations of the duty control circuit 104 controlling the first duty adjustment circuit 101A and the second duty adjustment circuit 101B are similar, the following description will be based on the control operation of the first duty adjustment circuit 101A.

The duty control circuit 104 may change the first code CC<m:0> by a basic unit within an adjustable range (for example, a first adjustable range) for each cycle of the first section and change the second code CF<n:0> by the maximum value within an adjustable range (for example, a second adjustable range) to detect the bang-bang state of the first code CC<m:0> and complete the first correction operation. Further, the duty control circuit 104 may fix the first code CC<m:0> and adjust the second code CF<n:0> by a basic unit for each cycle of the second section to detect the bang-bang state of the second code CF<n:0> and complete the second correction operation.

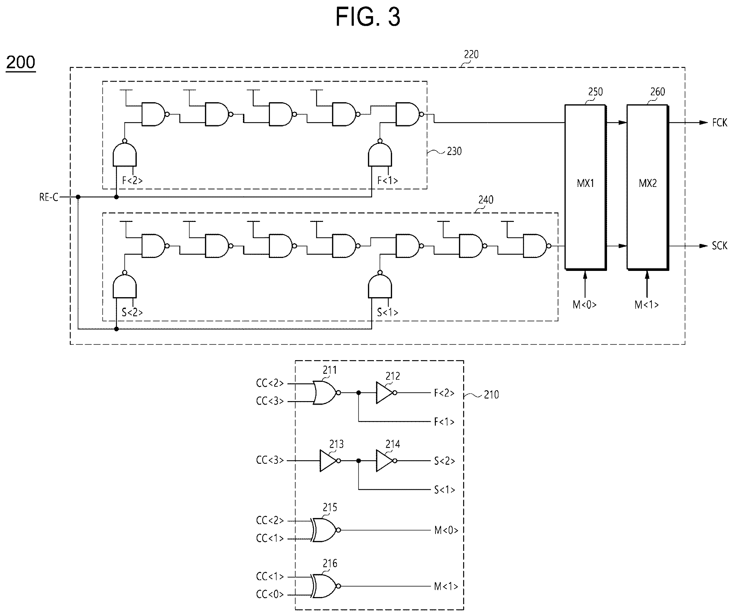

FIG. 3 is a diagram illustrating a detailed configuration of the first adjustment circuit 200 of FIG. 2, according to an embodiment of the present disclosure.

In the following description, an example will be described in which the duty cycle correction circuit 100 is configured such that 'm' is '3' and 'n' is '7' among the plurality of codes CC<m:0>, CF<n:0>, NC<m:0>, and NF<n:0>.

Referring to FIG. 3, the first adjustment circuit 200 may include a delay control signal generation circuit 210 and a delay circuit 220.

The delay control signal generation circuit 210 may receive a first code CC<3:0> and may output a plurality of delay control signals F<2:1>, S<2:1>, and M<1:0>. The delay control signal generation circuit 210 may include a plurality of logic gates 211 to 216. The first logic gate 211 may output a result obtained by performing a NOR operation on the first code CC<2> and the first code CC<3> as the delay control signal F<1>. The second logic gate 212 may output a result obtained by inverting the delay control signal F<1> as the delay control signal F<2>. The third logic gate 213 may output a result obtained by inverting the first code CC<3> as the delay control signal S<1>. The fourth logic gate 214 may output a result obtained by inverting the delay control signal S<1> as the delay control signal S<2>. The fifth logic gate 215 may output a result obtained by performing an exclusive OR operation on the first code CC<2> and the first code CC<1> as the delay control signal M<0>. The sixth logic gate 216 may output a result obtained by performing an exclusive OR operation on the first code CC<0> and the first code CC<1> as the delay control signal M<1>.

The delay circuit 220 may delay the first external clock signal RE-C by a time corresponding to the plurality of delay control signals F<2:1>, S<2:1>, and M<1:0> to generate the first clock signal FCK and the second clock signal SCK. The delay circuit 220 may include a first delay line 230, a second delay line 240, a first phase mixing circuit MX1 250, and a second phase mixing circuit MX2 260. The first delay line 230 may delay the first external clock signal RE-C by a time corresponding to the plurality of delay control signals F<2:1> and may output the result. The first delay line 230 may be configured by a plurality of logic gates, for example, a plurality of NAND gates, and may adjust a delay time of the first external clock signal RE-C by changing the number of NAND gates through which the first external clock signal RE-C passes according to the plurality of delay control signals F<2:1>. The second delay line 240 may delay the first external clock signal RE-C by a time corresponding to the plurality of delay control signals S<2:1> and may output the result. The first phase mixing circuit 250 may output a result obtained by mixing outputs of the first delay line 230 and the second delay line 240 at a ratio determined according to the delay control signal M<0>. The second phase mixing circuit 260 may output a result obtained by mixing outputs of the first delay line 230 and the second delay line 240 at a ratio determined according to the delay control signal M<1> as the first clock signal FCK and the second clock signal SCK.

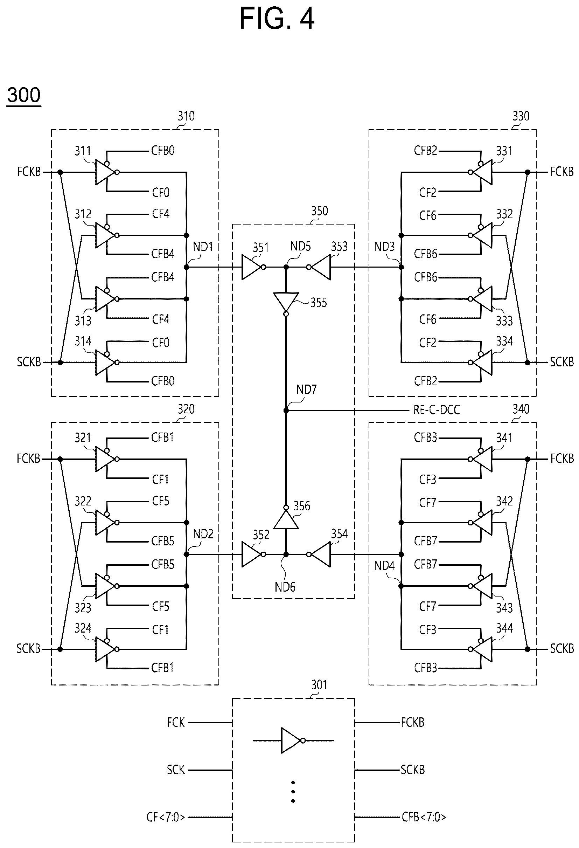

FIG. 4 is a diagram illustrating a detailed configuration of the second adjustment circuit 300 of FIG. 2, according to an embodiment of the present disclosure.

Referring to FIG. 4, the second adjustment circuit 300 may include an inverter circuit 301, a plurality of pre-circuits 310, 320, 330, and 340, and a main circuit 350.

The inverter circuit 301 may invert the first clock signal FCK, the second clock signal SCK, and the second code CF<7:0> to generate an inverted first clock signal FCKB, an inverted second clock signal SCKB, and an inverted second code CFB<7:0>. The inverter circuit 301 may include a plurality of inverters.

The plurality of pre-circuits 310, 320, 330, and 340 may selectively output one of the inverted first clock signal FCKB and the inverted second clock signal SCKB according to the second code CF<7:0> and the inverted second code CFB<7:0>.

The first pre-circuit 310 may selectively output one of the inverted first clock signal FCKB and the inverted second clock signal SCKB according to the second code CF0, CF4 and the inverted second code CFB0, CFB4. The first pre-circuit 310 may include a plurality of logic gates 311 to 314. Outputs of the plurality of logic gates 311 to 314 may be connected in common to a first node ND1.

The second pre-circuit 320 may selectively output one of the inverted first clock signal FCKB and the inverted second clock signal SCKB according to the second code CF1, CF5 and the inverted second code CFB1, CFB5. The second pre-circuit 320 may include a plurality of logic gates 321 to 324. Outputs of the plurality of logic gates 321 to 324 may be connected in common to a second node ND2.

The third pre-circuit 330 may selectively output one of the inverted first clock signal FCKB and the inverted second clock signal SCKB according to the second code CF2, CF6 and the inverted second code CFB2, CFB6. The third pre-circuit 330 may include a plurality of logic gates 331 to 334. Outputs of the plurality of logic gates 331 to 334 may be connected in common to a third node ND3.

The fourth pre-circuit 340 may selectively output one of the inverted first clock signal FCKB and the inverted second clock signal SCKB according to the second code CF3, CF7 and the inverted second code CFB3, CFB7. The fourth pre-circuit 340 may include a plurality of logic gates 341 to 344. Outputs of the plurality of logic gates 341 to 344 may be connected in common to a fourth node ND4.

Because the plurality of pre-circuits 310, 320, 330, and 340 are similarly configured and operate similarly, the configuration and operation of one of them, for example, the first pre-circuit 310, will be described and is representative of the others. The first logic gate 311 may invert the inverted first clock signal FCKB and may output the result to the first node ND1 if the second code CF0 is at a logic high level. The second logic gate 312 may invert the inverted second clock signal SCKB and may output the result to the first node ND1 if the second code CF4 is at a logic low level. The third logic gate 313 may invert the inverted first clock signal FCKB and may output the result to the first node ND1 if the second code CF4 is at a logic high level. The fourth logic gate 314 may invert the inverted second clock signal SCKB and may output the result to the first node ND1 if the second code CF0 is at a logic low level.

The main circuit 350 may output, as the first duty correction clock signal RE-C-DCC, a result obtained by mixing phases of signals output from the plurality of pre-circuits 310, 320, 330, and 340, which are applied to the first to fourth nodes ND1 to ND4. The main circuit 350 may include a plurality of logic gates 351 to 356. The first logic gate 351 may invert the signal of the first node ND1 and may output the result to a fifth node ND5. The second logic gate 352 may invert the signal of the second node ND2 and may output the result to a sixth node ND6. The third logic gate 353 may invert the signal of the third node ND3 and may output the result to the fifth node ND5. The fourth logic gate 354 may invert the signal of the fourth node ND4 and may output the result to the sixth node ND6. The fifth logic gate 355 may invert the signal of the fifth node ND5 and may output the result to a seventh node ND7. The sixth logic gate 356 may invert the signal of the sixth node ND6 and may output the result to the seventh node ND7. The first duty correction clock signal RE-C-DCC may be output through the seventh node ND7.

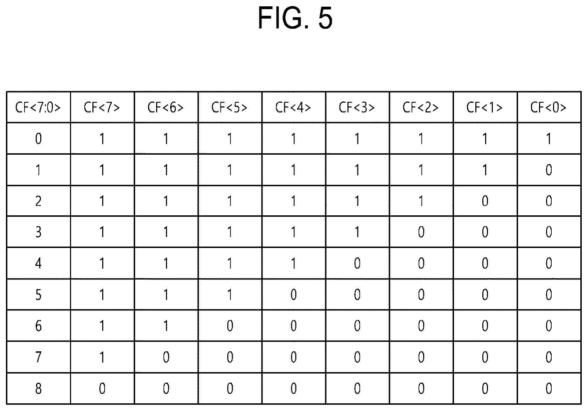

FIG. 5 is a diagram for describing a method of changing the second code, according to an embodiment of the present disclosure.

Referring to FIG. 5, there is shown an illustrative example where the second code CF<7:0> is divided from "0" to "8". A configuration method of the second code CF<7:0> may vary depending on a code control method, a circuit design method, or the like. "0" to "8" represents stages of the second code CF<7:0>, not decimal values. The second code CF<7:0> may have different values according to a Gray code method at each stage. The Gray code method is a method in which, as a stage increases or decreases, the number of bits having a value of "1" (binary) or "0" (binary) among all bits is increased or decreased by one. For example, in the second code CF<7:0>, all bits may be set to "1" at a "0" stage, and when adjusted to a "1" stage, CF<0> may change to "0" while the other bits maintain "1", and when adjusted to a "2" stage, CF<1> may change to "0" compared to the "1" stage while the other bits maintain "1" and CF<0> maintains "0". As the stage changes in the above-described manner, the number of bits having a value of "1" may decrease, and the number of bits having a value of "0" may increase. Note that this example is provided for purposes of particular explanation, and there may be implementations in which all bits are initially set to "0" at the "0" stage, and as the stage changes, the number of bits having a value of "0" decreases and the number of bits having a value of "1" increases.

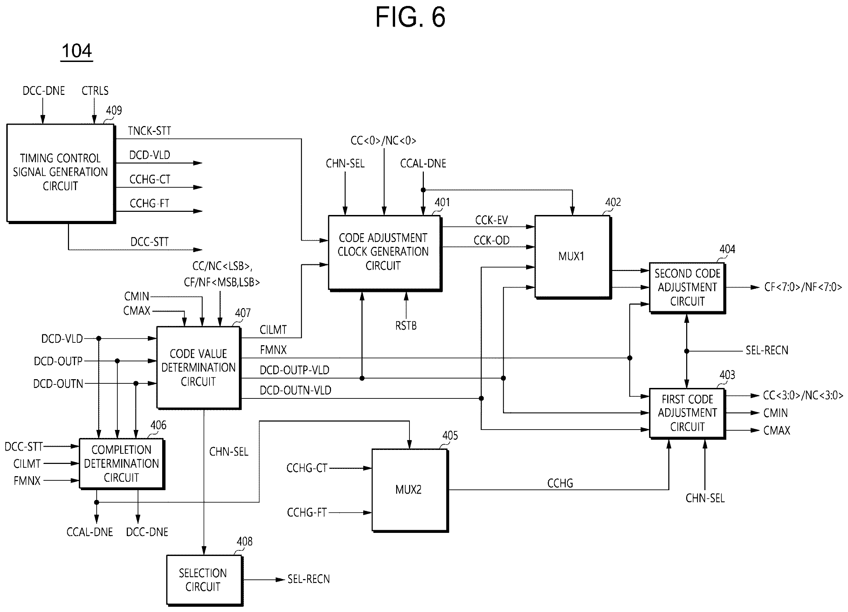

FIG. 6 is a diagram illustrating a detailed configuration of the duty control circuit 104 of FIG. 2, according to an embodiment of the present disclosure.

Referring to FIG. 6, the duty control circuit 104 may include a code adjustment clock generation circuit 401, a first multiplexer MUX1 402, a first code adjustment circuit 403, a second code adjustment circuit 404, a second multiplexer MUX2 405, a completion determination circuit 406, a code value determination circuit 407, and a selection circuit 408. The duty control circuit 104 may further include a timing control signal generation circuit 409. The timing control signal generation circuit 409 may generate a plurality of timing control signals TNCK-STT, DCD-VLD, CCHG-CT, CCHG-FT, and DCC-STT related to operation timing of the duty control circuit 104.

FIG. 6 is merely an example in which the duty control circuit 104 includes the timing control signal generation circuit 409, and in a system including the duty cycle correction circuit 100 rather than the duty cycle correction circuit 100 itself, the plurality of timing control signals TNCK-STT, DCD-VLD, CCHG-CT, CCHG-FT, and DCC-STT may be generated and provided to the duty cycle correction circuit 100.

The code adjustment clock generation circuit 401 may generate a plurality of code adjustment clock signals CCK-EV and CCK-OD for changing the second code CF<7:0> by the maximum value within an adjustable range at each cycle during the first section from a time at which the adjustment of the first code CC<3:0> starts to a time at which a first code adjustment completion signal CCAL-DNE is activated.

The code adjustment clock generation circuit 401 may also generate the plurality of code adjustment clock signals CCK-EV and CCK-OD for changing the fourth code NF<7:0> by the maximum value within an adjustable range at each cycle during the first section from a time at which the adjustment of the third code NC<3:0> starts to a time at which the first code adjustment completion signal CCAL-DNE is activated.

The duty cycle correction circuit 100 may perform a duty correction operation by switching between a first code set CC<3:0> and CF<7:0> and a second code set NC<3:0> and NF<7:0>. Detailed descriptions thereof will be provided later referring to operations of the code value determination circuit 407, the selection circuit 408, the first code adjustment circuit 403, and the second code adjustment circuit 404. Accordingly, the code adjustment clock generation circuit 401 may receive the first code CC<0> and the third code NC<0> and selectively use one of them.

The code adjustment clock generation circuit 401 may receive a clock adjustment start signal TNCK-STT, a code set change signal CHN-SEL, a currently selected code between the first code CC<0> and the third code NC<0>, a first code increment limit detection signal CILMT, a first duty detection valid signal DCD-OUTP-VLD, a first code adjustment completion signal CCAL-DNE, and a reset signal RSTB, and may output the plurality of code adjustment clock signals CCK-EV and CCK-OD. The plurality of code adjustment clock signals CCK-EV and CCK-OD may include a first adjustment clock signal CCK-EV and a second adjustment clock signal CCK-OD.

The first multiplexer 402 may receive the plurality of code adjustment clock signals CCK-EV and CCK-OD, the first duty detection valid signal DCD-OUTP-VLD, a second duty detection valid signal DCD-OUTN-VLD, and the first code adjustment completion signal CCAL-DNE, and may output the plurality of code adjustment clock signals CCK-EV and CCK-OD or output the first duty detection valid signal DCD-OUTP-VLD and the second duty detection valid signal DCD-OUTN-VLD.

The first multiplexer 402 may selectively output the plurality of code adjustment clock signals CCK-EV and CCK-OD or the plurality of duty detection valid signals DCD-OUTP-VLD and DCD-OUTN-VLD according to the first code adjustment completion signal CCAL-DNE.

The first multiplexer 402 may output the first adjustment clock signal CCK-EV and the second adjustment clock signal CCK-OD when the first code adjustment completion signal CCAL-DNE is deactivated, and may output the first duty detection valid signal DCD-OUTP-VLD and the second duty detection valid signal DCD-OUTN-VLD when the first code adjustment completion signal CCAL-DNE is activated.

The first code adjustment circuit 403 may receive the first duty detection valid signal DCD-OUTP-VLD, the second duty detection valid signal DCD-OUTN-VLD, a second code minimum/maximum detection signal FMNX, a code change timing signal CCHG, a code set selection signal SEL-RECN, and a code set change signal CHN-SEL, and may output a first code minimum detection signal CMIN, a first code maximum detection signal CMAX, the first code CC<3:0>, and the third code NC<3:0>.

The first code adjustment circuit 403 may activate the first code minimum detection signal CMIN to a logic high level when the first code CC<3:0> and the third code NC<3:0> are at a minimum stage, and may activate the first code maximum detection signal CMAX to a logic high level when the first code CC<3:0> and the third code NC<3:0> are at a maximum stage.

The first code adjustment circuit 403 may increase or decrease a selected code between the first code CC<3:0> and the third code NC<3:0> according to the first duty detection valid signal DCD-OUTP-VLD and the second duty detection valid signal DCD-OUTN-VLD when the code change timing signal CCHG is activated.

The first code adjustment circuit 403 may increase or decrease a selected code between the first code CC<3:0> and the third code NC<3:0> according to the first duty detection valid signal DCD-OUTP-VLD and the second duty detection valid signal DCD-OUTN-VLD when the second code minimum/maximum detection signal FMNX and the code change timing signal CCHG are activated.

The first code adjustment circuit 403 may increase a selected code between the first code CC<3:0> and the third code NC<3:0> if the first duty detection valid signal DCD-OUTP-VLD is at a logic high level while the second code minimum/maximum detection signal FMNX and the code change timing signal CCHG are activated.

The first code adjustment circuit 403 may decrease a selected code between the first code CC<3:0> and the third code NC<3:0> if the second duty detection valid signal DCD-OUTN-VLD is at a logic high level while the second code minimum/maximum detection signal FMNX and the code change timing signal CCHG are activated.

The first code adjustment circuit 403 may output the third code NC<3:0> as an initial value and adjust the first code CC<3:0> when the code set selection signal SEL-RECN is at a logic high level, and may output the first code CC<3:0> as an initial value and adjust the third code NC<3:0> when the code set selection signal SEL-RECN is at a second logic level, for example, a logic low level.

The first code adjustment circuit 403 may block variations of the first code CC<3:0> and the third code NC<3:0> according to the second code minimum/maximum detection signal FMNX and the code set change signal CHN-SEL. The first code adjustment circuit 403 may block variations of the first code CC<3:0> and the third code NC<3:0> when the second code minimum/maximum detection signal FMNX is deactivated. The first code adjustment circuit 403 may block variations of the first code CC<3:0> and the third code NC<3:0> when the code set change signal CHN-SEL is activated.

The second code adjustment circuit 404 may receive an output of the first multiplexer 402, the second code minimum/maximum detection signal FMNX, and the code set selection signal SEL-RECN, and may output the second code CF<7:0> and the fourth code NF<7:0>.

The second code adjustment circuit 404 may increase or decrease a selected code between the second code CF<7:0> and the fourth code NF<7:0> according to the output of the first multiplexer 402.

The second code adjustment circuit 404 may output the fourth code NF<7:0> as an initial value and adjust the second code CF<7:0> when the code set selection signal SEL-RECN is at a logic high level, and may output the second code CF<7:0> as an initial value and adjust the fourth code NF<7:0> when the code set selection signal SEL-RECN is at a logic low level.

The second multiplexer 405 may receive a first change timing signal CCHG-CT, a second change timing signal CCHG-FT, and the first code adjustment completion signal CCAL-DNE, and may output the code change timing signal CCHG.

The second multiplexer 405 may output the first change timing signal CCHG-CT as the code change timing signal CCHG when the first code adjustment completion signal CCAL-DNE is deactivated. The second multiplexer 405 may output the second change timing signal CCHG-FT as the code change timing signal CCHG when the first code adjustment completion signal CCAL-DNE is activated.

The completion determination circuit 406 may receive the first duty detection signal DCD-OUTP, the second duty detection signal DCD-OUTN, a duty adjustment start signal DCC-STT, the first code increment limit detection signal CILMT, and the second code minimum/maximum detection signal FMNX, and may output the first code adjustment completion signal CCAL-DNE and a duty adjustment completion signal DCC-DNE.

The completion determination circuit 406 may activate the first code adjustment completion signal CCAL-DNE to a logic high level by detecting a bang-bang state of the first code CC<3:0> and the third code NC<3:0> according to the first duty detection signal DCD-OUTP and the second duty detection signal DCD-OUTN when the first code adjustment completion signal CCAL-DNE is deactivated to a logic low level. The activation of the first code adjustment completion signal CCAL-DNE may indicate that the adjustment of the first code CC<3:0> and the third code NC<3:0> has been completed.

The completion determination circuit 406 may maintain the first code adjustment completion signal CCAL-DNE at a logic low level if a bang-bang state of the first code CC<3:0> and the third code NC<3:0> is not detected according to the first duty detection signal DCD-OUTP and the second duty detection signal DCD-OUTN when the first code adjustment completion signal CCAL-DNE is deactivated.

The completion determination circuit 406 may activate the first code adjustment completion signal CCAL-DNE when the first code increment limit detection signal CILMT is activated, that is, when the currently adjusted one among the first code CC<3:0> and the third code NC<3:0> cannot be adjusted any further.

The completion determination circuit 406 may activate the duty adjustment completion signal DCC-DNE to a logic high level by detecting a bang-bang state of the second code CF<7:0> and the fourth code NF<7:0> according to the first duty detection signal DCD-OUTP and the second duty detection signal DCD-OUTN when the first code adjustment completion signal CCAL-DNE is activated.

The completion determination circuit 406 may deactivate the duty adjustment completion signal DCC-DNE to a logic low level if a bang-bang state of the second code CF<7:0> and the fourth code NF<7:0> is not detected according to the first duty detection signal DCD-OUTP and the second duty detection signal DCD-OUTN when the first code adjustment completion signal CCAL-DNE is activated.

The completion determination circuit 406 may activate the duty adjustment completion signal DCC-DNE when a predetermined time has elapsed by counting the valid section signal DCD-VLD.

The completion determination circuit 406 may activate the duty adjustment completion signal DCC-DNE when the first code increment limit detection signal CILMT and the second code minimum/maximum detection signal FMNX are both activated, that is, when no further code adjustment is possible.

The code value determination circuit 407 may receive the valid section signal DCD-VLD, the duty detection signals DCD-OUTP and DCD-OUTN, the first code minimum detection signal CMIN, the first code maximum detection signal CMAX, the least significant bits of the first code and the third code CC<0>/NC<0>, and the most significant and least significant bits of the second code and the fourth code CF<7,0>/NF<7,0>, and may output the first code increment limit detection signal CILMT, the second code minimum/maximum detection signal FMNX, the first duty detection valid signal DCD-OUTP-VLD, the second duty detection valid signal DCD-OUTN-VLD, and the code set change signal CHN-SEL.

The code value determination circuit 407 may generate and output the first duty detection valid signal DCD-OUTP-VLD and the second duty detection valid signal DCD-OUTN-VLD based on the duty detection signals DCD-OUTP and DCD-OUTN corresponding to the valid section signal DCD-VLD.

The code value determination circuit 407 may generate the first code increment limit detection signal CILMT, the second code minimum/maximum detection signal FMNX, and the code set change signal CHN-SEL based on the first code minimum detection signal CMIN, the first code maximum detection signal CMAX, the least significant bits of the first code and the third code CC<0>/NC<0>, the most significant and least significant bits of the second code and the fourth code CF<7,0>/NF<7,0>, the first duty detection valid signal DCD-OUTP-VLD, and the second duty detection valid signal DCD-OUTN-VLD.

The code value determination circuit 407 may determine that the first code CC<3:0> and the third code NC<3:0> are at a minimum stage according to the first code minimum detection signal CMIN, and may determine that the first code CC<3:0> and the third code NC<3:0> are at a maximum stage according to the first code maximum detection signal CMAX. The code value determination circuit 407 may determine that the second code CF<7:0> and the fourth code NF<7:0> are each at a minimum stage or a maximum stage according to the most significant and least significant bits of the second code and the fourth code CF<7,0>/NF<7,0>.

The code value determination circuit 407 may activate the code set change signal CHN-SEL to a logic high level when all of the plurality of codes CC<3:0>, CF<7:0>, NC<3:0>, and NF<7:0> are at a minimum stage and the second duty detection valid signal DCD-OUTN-VLD is at a high level.

The code value determination circuit 407 may activate the first code increment limit detection signal CILMT to a logic high level when the first code maximum detection signal CMAX is activated and the first duty detection valid signal DCD-OUTP-VLD is at a high level.

The code value determination circuit 407 may activate the second code minimum/maximum detection signal FMNX to a logic high level when the least significant bit of the first code CC<3:0> is at a low level, the second code CF<7:0> and the fourth code NF<7:0> are at a minimum stage, and the second duty detection valid signal DCD-OUTN-VLD is at a high level. The code value determination circuit 407 may activate the second code minimum/maximum detection signal FMNX to a logic high level when the least significant bit of the first code CC<3:0> is at a high level, the second code CF<7:0> and the fourth code NF<7:0> are at a maximum stage, and the second duty detection valid signal DCD-OUTN-VLD is at a high level. The code value determination circuit 407 may activate the second code minimum/maximum detection signal FMNX to a logic high level when the least significant bit of the first code CC<3:0> is at a low level, the second code CF<7:0> and the fourth code NF<7:0> are at a maximum stage, and the first duty detection valid signal DCD-OUTP-VLD is at a high level. The code value determination circuit 407 may activate the second code minimum/maximum detection signal FMNX to a logic high level when the least significant bit of the first code CC<3:0> is at a high level, the second code CF<7:0> and the fourth code NF<7:0> are at a minimum stage, and the first duty detection valid signal DCD-OUTP-VLD is at a high level.

The selection circuit 408 may receive the code set change signal CHN-SEL and may output the code set selection signal SEL-RECN. The selection circuit 408 may output the code set selection signal SEL-RECN at a logic level opposite to the previous logic level when the code set change signal CHN-SEL is activated.

The timing control signal generation circuit 409 may receive the plurality of control signals CTRLS and the duty adjustment completion signal DCC-DNE, and may output the plurality of timing control signals TNCK-STT, DCD-VLD, CCHG-CT, CCHG-FT, and DCC-STT. The plurality of control signals CTRLS may include signals related to starting and ending operations of the duty cycle correction circuit 100.

The timing control signal generation circuit 409 may generate the plurality of timing control signals TNCK-STT, DCD-VLD, CCHG-CT, CCHG-FT, and DCC-STT according to a plurality of cycles in the entire section where the duty cycle correction operation is performed.

The timing control signal generation circuit 409 may initialize the plurality of timing control signals TNCK-STT, DCD-VLD, CCHG-CT, CCHG-FT, and DCC-STT according to the duty adjustment completion signal DCC-DNE. The plurality of timing control signals TNCK-STT, DCD-VLD, CCHG-CT, CCHG-FT, and DCC-STT may include a clock adjustment start signal TNCK-STT, the valid section signal DCD-VLD, the first change timing signal CCHG-CT, the second change timing signal CCHG-FT, and the duty adjustment start signal DCC-STT.

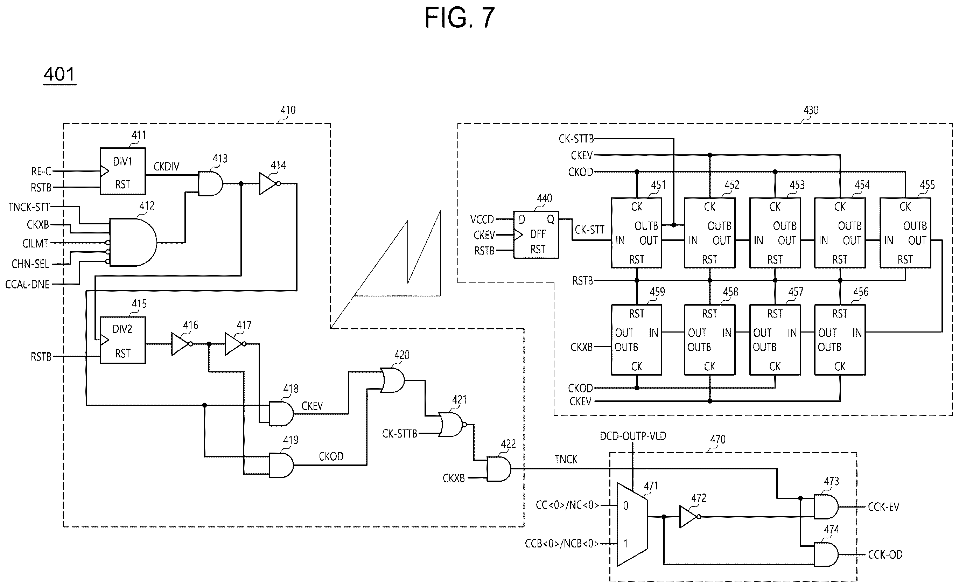

FIG. 7 is a diagram illustrating a detailed configuration of the code adjustment clock generation circuit 401 of FIG. 6, according to an embodiment of the present disclosure.

Referring to FIG. 7, the code adjustment clock generation circuit 401 may include a source clock generation circuit 410, a shifting circuit 430, and an adjustment clock generation circuit 470.

The source clock generation circuit 410 may receive the first external clock signal RE-C, a source clock generation start signal TNCK-STT, the first code increment limit detection signal CILMT, a plurality of adjustment clock section signals CK-STTB and CKXB, the code set change signal CHN-SEL, and the first code adjustment completion signal CCAL-DNE, and may output a source clock signal TNCK.

The source clock generation circuit 410 may divide the first external clock signal RE-C to generate a plurality of divided clock signals CKEV and CKOD, and may output pulses corresponding to a section determined by the plurality of adjustment clock section signals CK-STTB and CKXB among pulses of the plurality of divided clock signals CKEV and CKOD as the source clock signal TNCK.

The source clock generation circuit 410 may include a plurality of divider circuits 411 and 415 and a plurality of logic gates 412 to 414 and 416 to 422. The first divider circuit 411 may divide the first external clock signal RE-C by two to generate an external clock divided signal CKDIV. The first logic gate 412 may output a result obtained by performing an AND operation on the source clock generation start signal TNCK-STT, a second adjustment clock section signal CKXB, an inverted first code increment limit detection signal CILMT, an inverted code set change signal CHN-SEL, and an inverted first code adjustment completion signal CCAL-DNE. The second logic gate 413 may output a result obtained by performing an AND operation on the external clock divided signal CKDIV and an output of the first logic gate 412. The third logic gate 414 may invert and output an output of the second logic gate 413. The second divider circuit 415 may divide the output of the second logic gate 413 by two and output the result. The fourth logic gate 416 may invert and output an output of the second divider circuit 415. The fifth logic gate 417 may invert and output an output of the fourth logic gate 416. The sixth logic gate 418 may output a result obtained by performing an AND operation on an output of the third logic gate 414 and an output of the fifth logic gate 417 as an even divided clock signal CKEV among the plurality of divided clock signals CKEV and CKOD. The seventh logic gate 419 may output a result obtained by performing an AND operation on the output of the third logic gate 414 and the output of the fourth logic gate 416 as an odd divided clock signal CKOD among the plurality of divided clock signals CKEV and CKOD. The eighth logic gate 420 may output a result obtained by performing an OR operation on outputs of the sixth logic gate 418 and the seventh logic gate 419. The ninth logic gate 421 may output a result obtained by performing a NOR operation on an output of the eighth logic gate 420 and the first adjustment clock section signal CK-STTB. The tenth logic gate 422 may output a result obtained by performing an AND operation on an output of the ninth logic gate 421 and the second adjustment clock section signal CKXB as the source clock signal TNCK. The plurality of divider circuits 411 and 415 may initialize outputs according to the reset signal RSTB.

The source clock generation circuit 410 may generate the source clock signal TNCK only when the first code increment limit detection signal CILMT, the code set change signal CHN-SEL, and the first code adjustment completion signal CCAL-DNE are all deactivated, and may block the generation of the source clock signal TNCK if any one of the first code increment limit detection signal CILMT, the code set change signal CHN-SEL, and the first code adjustment completion signal CCAL-DNE is activated.

The shifting circuit 430 may receive the plurality of divided clock signals CKEV and CKOD and may output the plurality of adjustment clock section signals CK-STTB and CKXB. The shifting circuit 430 may shift a power level VCCD according to the plurality of divided clock signals CKEV and CKOD to generate the plurality of adjustment clock section signals CK-STTB and CKXB. The plurality of divided clock signals CKEV and CKOD may include the even divided clock signal CKEV and the odd divided clock signal CKOD.

The shifting circuit 430 may include a flip-flop 440 and a plurality of shifting units 451 to 459. The flip-flop 440 may latch the power level VCCD according to the even divided clock signal CKEV to generate a shifting start signal CK-STT. The plurality of shifting units 451 to 459 may shift the shifting start signal CK-STT according to the plurality of divided clock signals CKEV and CKOD to generate the plurality of adjustment clock section signals CK-STTB and CKXB. Among the plurality of shifting units 451 to 459, even-numbered shifting units 452, 454, 456, and 458 may shift and output an input signal according to the even divided clock signal CKEV, and odd-numbered shifting units 451, 453, 455, 457, and 459 may shift and output an input signal according to the odd divided clock signal CKOD. Among the plurality of shifting units 451 to 459, the first shifting unit 451 may output an inverted signal as the first adjustment clock section signal CK-STTB. The second to eighth shifting units 452 to 458 may shift and output an output of a preceding shifting unit according to the plurality of divided clock signals CKEV and CKOD. The ninth shifting unit 459 may output an inverted signal of an output of the eighth shifting unit 458 as the second adjustment clock section signal CKXB.

The adjustment clock generation circuit 470 may receive the source clock signal TNCK, the least significant bits CC<0>/NC<0> of the first code CC<3:0> and the third code NC<3:0>, an inverted least significant bits CCB<0>/NCB<0> generated by inverting the least significant bits, and the first duty detection valid signal DCD-OUTP-VLD, and may output the plurality of code adjustment clock signals CCK-EV and CCK-OD.

The adjustment clock generation circuit 470 may generate the plurality of code adjustment clock signals CCK-EV and CCK-OD according to the source clock signal TNCK. The adjustment clock generation circuit 470 may select and output one of the plurality of code adjustment clock signals CCK-EV and CCK-OD according to the least significant bits CC<0>/NC<0> of the first code CC<3:0> and the third code NC<3:0> and the first duty detection valid signal DCD-OUTP-VLD, and may block the output of the other.

The adjustment clock generation circuit 470 may include a multiplexer 471 and a plurality of logic gates 472 to 474. The multiplexer 471 may select and output one of the least significant bits CC<0>/NC<0> and the inverted least significant bits CCB<0>/NCB<0> according to the first duty detection valid signal DCD-OUTP-VLD. For example, assuming that the first code set CC<3:0> and CF<7:0> is selected, the multiplexer 471 may select and output one of the least significant bit CC<0> and the inverted least significant bit CCB<0>. The first logic gate 472 may invert and output an output of the multiplexer 471. The second logic gate 473 may output a result obtained by performing an AND operation on the source clock signal TNCK and an output of the first logic gate 472 as the first adjustment clock signal CCK-EV. The third logic gate 474 may output a result obtained by performing an AND operation on the source clock signal TNCK and the output of the multiplexer 471 as the second adjustment clock signal CCK-OD. The adjustment clock generation circuit 470 may block the generation of the plurality of code adjustment clock signals CCK-EV and CCK-OD when the generation of the source clock signal TNCK is blocked.

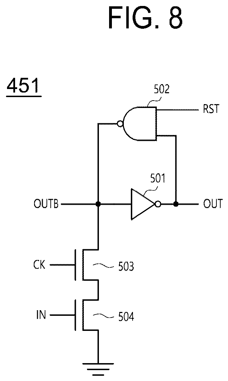

FIG. 8 is a diagram illustrating a detailed configuration of the shifting unit 451 of FIG. 7, according to an embodiment of the present disclosure.

Referring to FIG. 8, the shifting unit 451 may include logic gates 501 and 502 and transistors 503 and 504. The first logic gate 501 may invert a logic level of an inverted output terminal OUTB and apply the result to an output terminal OUT. The second logic gate 502 may apply a result obtained by performing a NOR operation on a logic level of the output terminal OUT and a logic level of a reset terminal RST to the inverted output terminal OUTB. The transistors 503 and 504 may be connected between the inverted output terminal OUTB and a ground terminal, and may operate according to signals at a clock terminal CK and an input terminal IN, respectively.

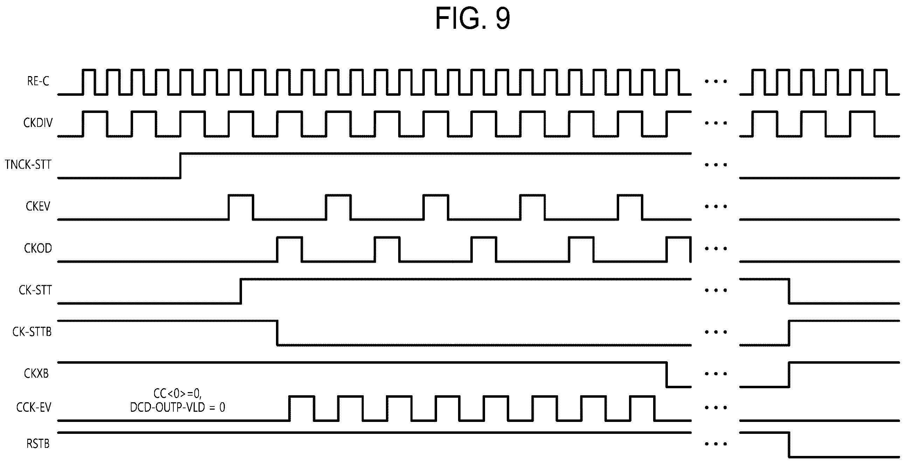

FIG. 9 is a timing diagram for describing an operation of the code adjustment clock generation circuit 401 of FIG. 7, according to an embodiment of the present disclosure.

Referring to FIG. 9, the code adjustment clock generation circuit 401 may divide the first external clock signal RE-C to generate the external clock divided signal CKDIV, which has a cycle time 1tCK corresponding to two cycle times 2tCK of the first external clock signal RE-C.

As the source clock generation start signal TNCK-STT is activated, the plurality of divided clock signals CKEV and CKOD may be generated.

When the shifting start signal CK-STT is activated, the first adjustment clock section signal CK-STTB may transition to a low level after one cycle time based on the external clock divided signal CKDIV, while the second adjustment clock section signal CKXB may remain at a high level.

At this time, when the least significant bit CC<0> and the first duty detection valid signal DCD-OUTP-VLD are at a logic low level '0', the first adjustment clock signal CCK-EV may be generated according to the plurality of divided clock signals CKEV and CKOD. Although not shown in FIG. 9, the second adjustment clock signal CCK-OD may remain in a low-level inactive state.

At the elapse of a predetermined time based on the plurality of divided clock signals CKEV and CKOD from the time point when the shifting start signal CK-STT is activated, the second adjustment clock section signal CKXB may transition to a low level.

As the second adjustment clock section signal CKXB transitions to a low level, the first adjustment clock signal CCK-EV may be initialized to a low level.

The first adjustment clock signal CCK-EV, having eight pulses, may be generated in a section (for example, within a time frame) from (i.e., that begins at) a time point when the first adjustment clock section signal CK-STTB transitions to a low level to (i.e., that ends at) a time point when the second adjustment clock section signal CKXB transitions to a low level.

Meanwhile, when the least significant bit CC<0> is at a logic low level and the first duty detection valid signal DCD-OUTP-VLD is at a logic high level, the second adjustment clock signal CCK-OD, having eight pulses, may be generated in the section from the time point when the first adjustment clock section signal CK-STTB transitions to a low level to the time point when the second adjustment clock section signal CKXB transitions to a low level, while the first adjustment clock signal CCK-EV remains in a low-level inactive state.

As the reset signal RSTB transitions to a low level, the shifting start signal CK-STT, the first adjustment clock section signal CK-STTB, and the second adjustment clock section signal CKXB may be initialized.

FIG. 5 previously described is an example in which the second code CF<7:0> is configured in stages from 0 to 8. In each cycle of the first section, to change the second code CF<7:0> from a predetermined stage, that is, from the lowest stage '0' to the highest stage '8' or from the highest stage '8' to the lowest stage '0', eight adjustments are required. Accordingly, the above description is based on an example in which the code adjustment clock generation circuit 401 is configured to generate the first adjustment clock signal CCK-EV and the second adjustment clock signal CCK-OD, each having eight pulses.

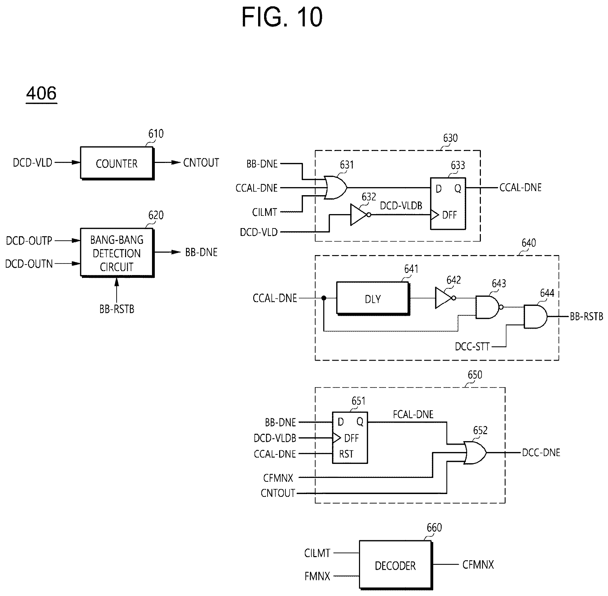

FIG. 10 is a diagram illustrating a detailed configuration of the completion determination circuit 406 of FIG. 6, according to an embodiment of the present disclosure.

Referring to FIG. 10, the completion determination circuit 406 may include a counter 610, a bang-bang detection circuit 620, a first signal generation circuit 630, a second signal generation circuit 640, a third signal generation circuit 650, and a decoder 660.

The counter 610 may count the valid section signal DCD-VLD and may output a count result signal CNTOUT. A duty correction operation should be performed within a time defined by an operating specification. The count result signal CNTOUT may be activated to a logic high level at a time defined in the operating specification to indicate a time limit of the duty correction operation.

The bang-bang detection circuit 620 may receive the first duty detection signal DCD-OUTP, the second duty detection signal DCD-OUTN, and a bang-bang reset signal BB-RSTB, and may output a bang-bang detection signal BB-DNE. The bang-bang detection circuit 620 may activate the bang-bang detection signal BB-DNE to a logic high level when the first duty detection signal DCD-OUTP and the second duty detection signal DCD-OUTN are alternately generated at a logic high level.

The first signal generation circuit 630 may receive the bang-bang detection signal BB-DNE, the first code adjustment completion signal CCAL-DNE, the first code increment limit detection signal CILMT, and the valid section signal DCD-VLD, and may output the first code adjustment completion signal CCAL-DNE. The first signal generation circuit 630 may maintain the first code adjustment completion signal CCAL-DNE in an activated state when any one of the bang-bang detection signal BB-DNE, the first code adjustment completion signal CCAL-DNE and the first code increment limit detection signal CILMT is activated after the valid section signal DCD-VLD is deactivated.

The first signal generation circuit 630 may include a plurality of logic gates 631 and 632 and a flip-flop 633. The first logic gate 631 may output a result obtained by performing an OR operation on the bang-bang detection signal BB-DNE, the first code adjustment completion signal CCAL-DNE, and the first code increment limit detection signal CILMT. The logic gate 632 may invert the valid section signal DCD-VLD and may output an inverted valid section signal DCD-VLDB. The flip-flop 633 may output an output of the logic gate 631 as the first code adjustment completion signal CCAL-DNE at a time point when the inverted valid section signal DCD-VLDB transitions to a logic high level.

The second signal generation circuit 640 may receive the first code adjustment completion signal CCAL-DNE and the duty adjustment start signal DCC-STT and may output the bang-bang reset signal BB-RSTB. The second signal generation circuit 640 may generate the bang-bang reset signal BB-RSTB in response to the activation of the first code adjustment completion signal CCAL-DNE.

The second signal generation circuit 640 may include a delay circuit 641 and a plurality of logic gates 642 to 644. The delay circuit 641 may delay the first code adjustment completion signal CCAL-DNE for a predetermined time and may output the result. The logic gate 642 may invert an output of the delay circuit 641. The logic gate 643 may output a result obtained by performing a NAND operation on an output of the logic gate 642 and the first code adjustment completion signal CCAL-DNE. The logic gate 644 may output a result obtained by performing an AND operation on an output of the logic gate 643 and the duty adjustment start signal DCC-STT as the bang-bang reset signal BB-RSTB.

The third signal generation circuit 650 may receive the bang-bang detection signal BB-DNE, the inverted valid section signal DCD-VLDB, the first code adjustment completion signal CCAL-DNE, a code adjustment limit detection signal CFMNX, and the count result signal CNTOUT, and may output the duty adjustment completion signal DCC-DNE. The third signal generation circuit 650 may activate the duty adjustment completion signal DCC-DNE when any one of the bang-bang detection signal BB-DNE, the code adjustment limit detection signal CFMNX, and the count result signal CNTOUT is activated after the first code adjustment completion signal CCAL-DNE is activated.

The third signal generation circuit 650 may include a flip-flop 651 and a logic gate 652. The flip-flop 651 may latch the bang-bang detection signal BB-DNE and may output the result as a second code adjustment completion signal FCAL-DNE when the inverted valid section signal DCD-VLDB is at a logic high level. The flip-flop 651 may initialize the second code adjustment completion signal FCAL-DNE to a logic low level when the first code adjustment completion signal CCAL-DNE is deactivated. The logic gate 652 may output a result obtained by performing an OR operation on the second code adjustment completion signal FCAL-DNE, the code adjustment limit detection signal CFMNX, and the count result signal CNTOUT as the duty adjustment completion signal DCC-DNE.

The decoder 660 may decode the first code increment limit detection signal CILMT and the second code minimum/maximum detection signal FMNX and may output the code adjustment limit detection signal CFMNX. The decoder 660 may activate the code adjustment limit detection signal CFMNX when both the first code increment limit detection signal CILMT and the second code minimum/maximum detection signal FMNX are activated. The activation of the code adjustment limit detection signal CFMNX may indicate that adjustment of the first code CC<3:0>, the third code NC<3:0>, the second code CF<7:0>, and the fourth code NF<7:0> is no longer possible.

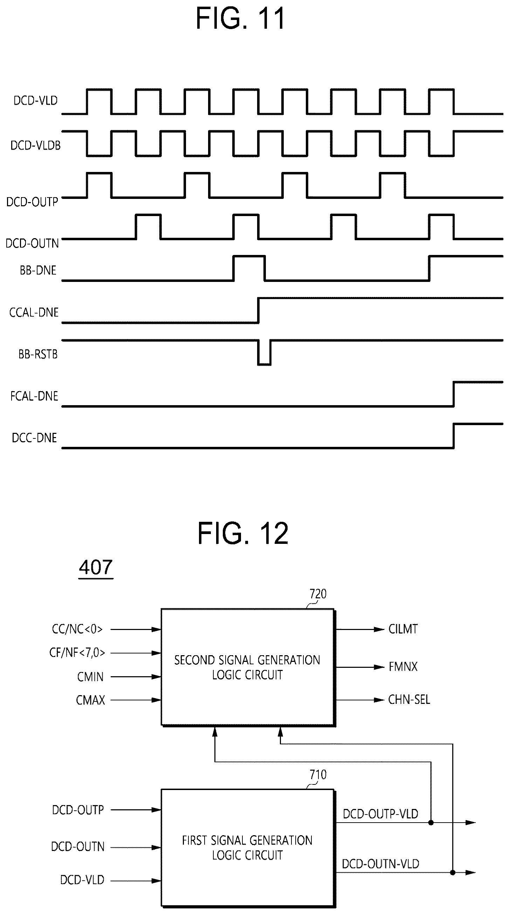

FIG. 11 is a timing diagram for describing an operation of the completion determination circuit 406 of FIG. 10, according to an embodiment of the present disclosure.

Referring to FIG. 11, the bang-bang detection signal BB-DNE may be activated to a logic high level as the first duty detection signal DCD-OUTP and the second duty detection signal DCD-OUTN are alternately generated at a logic high level for two cycles. The activation of the bang-bang detection signal BB-DNE may indicate that adjustment of the first code CC<3:0> and the third code NC<3:0> has been completed.

After the bang-bang detection signal BB-DNE is activated to a logic high level, the first code adjustment completion signal CCAL-DNE may be activated to a logic high level at a time when the inverted valid section signal DCD-VLDB transitions to a logic high level.

As the first code adjustment completion signal CCAL-DNE is activated, the bang-bang reset signal BB-RSTB may be activated to a logic low level, and accordingly, the bang-bang detection signal BB-DNE may be deactivated to a logic low level.

After the bang-bang detection signal BB-DNE is deactivated, the bang-bang detection signal BB-DNE may be reactivated to a logic high level according to the first duty detection signal DCD-OUTP and the second duty detection signal DCD-OUTN. The reactivation of the bang-bang detection signal BB-DNE may indicate that adjustment of the second code CF<7:0> and the fourth code NF<7:0> has been completed.

After the bang-bang detection signal BB-DNE is activated to a logic high level, the second code adjustment completion signal FCAL-DNE may be activated to a logic high level at a time when the inverted valid section signal DCD-VLDB transitions to a logic high level.

As the second code adjustment completion signal FCAL-DNE is activated, the duty adjustment completion signal DCC-DNE may be activated to a logic high level, indicating that the duty correction operation has been completed.

FIG. 12 is a diagram illustrating a detailed configuration of the code value determination circuit 407 of FIG. 6, according to an embodiment of the present disclosure.

Referring to FIG. 12, the code value determination circuit 407 may include a first signal generation logic circuit 710 and a second signal generation logic circuit 720.

The first signal generation logic circuit 710 may receive the valid section signal DCD-VLD, the first duty detection signal DCD-OUTP, and the second duty detection signal DCD-OUTN, and may output the first duty detection valid signal DCD-OUTP-VLD and the second duty detection valid signal DCD-OUTN-VLD. The first signal generation logic circuit 710 may output a result obtained by performing an AND operation on the first duty detection signal DCD-OUTP and the valid section signal DCD-VLD as the first duty detection valid signal DCD-OUTP-VLD, and may output a result obtained by performing an AND operation on the second duty detection signal DCD-OUTN and the valid section signal DCD-VLD as the second duty detection valid signal DCD-OUTN-VLD.

The second signal generation logic circuit 720 may receive the first duty detection valid signal DCD-OUTP-VLD, the second duty detection valid signal DCD-OUTN-VLD, the least significant bits of the first and third codes CC<0>/NC<0>, the most significant and least significant bits of each of the second and fourth codes CF<7, 0>/NF<7, 0>, the first code minimum detection signal CMIN, and the first code maximum detection signal CMAX, and may output the first code increment limit detection signal CILMT, the second code minimum/maximum detection signal FMNX, and the code set change signal CHN-SEL.

The second signal generation logic circuit 720 may determine that the first code CC<3:0> and the third code NC<3:0> are at a minimum stage according to the first code minimum detection signal CMIN, and may determine that the first code CC<3:0> and the third code NC<3:0> are at a maximum stage according to the first code maximum detection signal CMAX. The second signal generation logic circuit 720 may determine that the second code CF<7:0> and the fourth code NF<7:0> are each at a minimum stage or a maximum stage based on the most significant and least significant bits of the second and fourth codes CF<7, 0>/NF<7, 0>.

The second signal generation logic circuit 720 may activate the code set change signal CHN-SEL to a logic high level when all of the plurality of codes CC<3:0>, CF<7:0>, NC<3:0>, and NF<7:0> are at a minimum stage and the second duty detection valid signal DCD-OUTN-VLD is at a high level.

The second signal generation logic circuit 720 may activate the first code increment limit detection signal CILMT to a logic high level when the first code maximum detection signal CMAX is activated and the first duty detection valid signal DCD-OUTP-VLD is at a logic high level.

The second signal generation logic circuit 720 may activate the second code minimum/maximum detection signal FMNX to a logic high level when the least significant bit of the first code CC<3:0> is at a low level, the second code CF<7:0> and the fourth code NF<7:0> are at a minimum stage, and the second duty detection valid signal DCD-OUTN-VLD is at a high level. The second signal generation logic circuit 720 may activate the second code minimum/maximum detection signal FMNX to a logic high level when the least significant bit of the first code CC<3:0> is at a high level, the second code CF<7:0> and the fourth code NF<7:0> are at a maximum stage, and the second duty detection valid signal DCD-OUTN-VLD is at a high level. The second signal generation logic circuit 720 may activate the second code minimum/maximum detection signal FMNX to a logic high level when the least significant bit of the first code CC<3:0> is at a low level, the second code CF<7:0> and the fourth code NF<7:0> are at a maximum stage, and the first duty detection valid signal DCD-OUTP-VLD is at a high level. The second signal generation logic circuit 720 may activate the second code minimum/maximum detection signal FMNX to a logic high level when the least significant bit of the first code CC<3:0> is at a high level, the second code CF<7:0> and the fourth code NF<7:0> are at a minimum stage, and the first duty detection valid signal DCD-OUTP-VLD is at a high level.

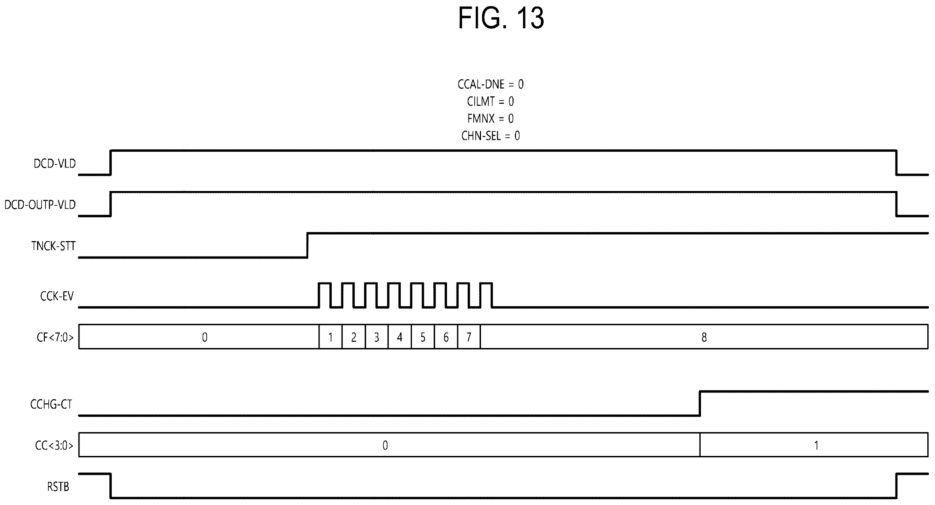

FIGS. 13 to 18 are timing diagrams for describing a duty cycle correction operation of the duty cycle correction circuit 100 according to an embodiment of the present disclosure. FIGS. 13 to 18 describe duty cycle correction operations under different state conditions based on the first code adjustment completion signal CCAL-DNE, the first code increment limit detection signal CILMT, the second code minimum/maximum detection signal FMNX, and the code set change signal CHN-SEL.

Referring to FIG. 13, a duty cycle correction operation will be described for a case where CCAL-DNE = '0', CILMT = '0', FMNX = '0', and CHN-SEL = '0'.

In a state in which the first code set CC<3:0> and CF<7:0> is selected, no code set change occurs because the code set change signal CHN-SEL is '0'. Because the first code adjustment completion signal CCAL-DNE is '0', optimization of the first code CC<3:0> has not yet been completed. As the first code increment limit detection signal CILMT and the second code minimum/maximum detection signal FMNX are both '0', it is possible to adjust the first code CC<3:0> and the second code CF<7:0>. It is assumed that both the first code CC<3:0> and the second code CF<7:0> are '0' at the activation point of the valid section signal DCD-VLD.

During an activation section of the valid section signal DCD-VLD, the first duty detection valid signal DCD-OUTP-VLD may be generated at a logic high level. The activation section of the valid section signal DCD-VLD corresponds to one cycle among multiple cycles of a duty correction operation section.

Because the second code CF<7:0> is in an adjustable state, the source clock generation start signal TNCK-STT may be activated first, and then the first change timing signal CCHG-CT may be activated after a predetermined timing margin.

As the source clock generation start signal TNCK-STT is activated, the first adjustment clock signal CCK-EV is generated, and the second code CF<7:0> is adjusted to '8' by being changed by the maximum value according to the first adjustment clock signal CCK-EV.

Because the first duty detection valid signal DCD-OUTP-VLD is at a logic high level, the first code CC<3:0> is increased to '1' according to the activated first change timing signal CCHG-CT.

After the first code CC<3:0> is adjusted to '1', the valid section signal DCD-VLD and the first duty detection valid signal DCD-OUTP-VLD are initialized by the reset signal RSTB.

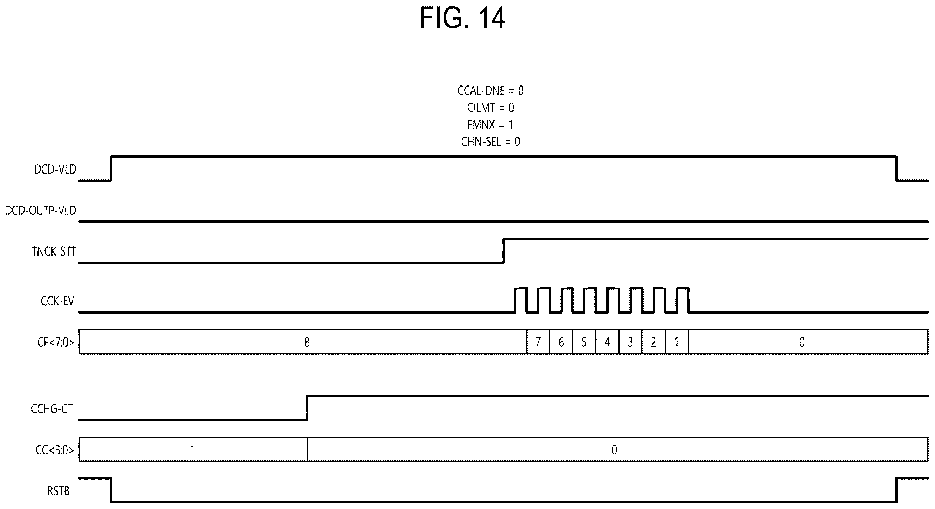

Referring to FIG. 14, the duty cycle correction operation will be described for a case where CCAL-DNE = '0', CILMT = '0', FMNX = '1', and CHN-SEL = '0'.

Because the code set selection signal SEL-RECN is '0', the first code set CC<3:0> and CF<7:0> is selected. Because the first code adjustment completion signal CCAL-DNE is '0', optimization of the first code CC<3:0> has not been completed. Because the first code increment limit detection signal CILMT is '0', the first code CC<3:0> is in an adjustable state, whereas the second code minimum/maximum detection signal FMNX is '1', indicating that the second code CF<7:0> is in an unadjustable state. It is assumed that the first code CC<3:0> is '1' and the second code CF<7:0> is '8' at the activation point of the valid section signal DCD-VLD.

During an activation section of the valid section signal DCD-VLD, the first duty detection valid signal DCD-OUTP-VLD may be generated at a logic low level. The activation section of the valid section signal DCD-VLD corresponds to one cycle among multiple cycles included in the duty correction operation section.

Because the second code CF<7:0> is in an unadjustable state, the first change timing signal CCHG-CT is activated first, and then the source clock generation start signal TNCK-STT is activated after a predetermined timing margin.

Because the first duty detection valid signal DCD-OUTP-VLD is at a logic low level, the first code CC<3:0> is decreased to '0' according to the activated first change timing signal CCHG-CT.

As the source clock generation start signal TNCK-STT is activated, the first adjustment clock signal CCK-EV is generated, and the second code CF<7:0> is adjusted to '0' by being changed by the maximum value according to the first adjustment clock signal CCK-EV.

After the first code CC<3:0> is adjusted to '0', the valid section signal DCD-VLD and the first duty detection valid signal DCD-OUTP-VLD are initialized by the reset signal RSTB.

As described with reference to FIGS. 13 and 14, in embodiments of the present disclosure, the second code CF<7:0> is changed by the maximum value within an adjustable range in each cycle included in the duty correction operation, thereby reducing the time required to complete the adjustment of the first code CC<3:0>.

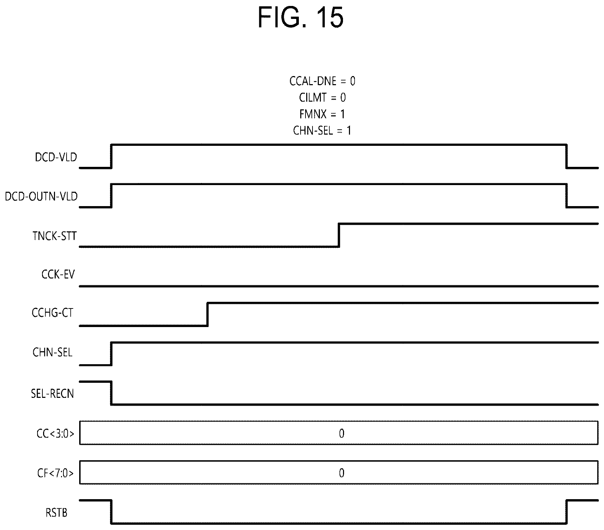

Referring to FIG. 15, a duty cycle correction operation will be described for a case where CCAL-DNE = '0', CILMT = '0', FMNX = "1", and CHN-SEL = '1'.

Because the first code adjustment completion signal CCAL-DNE is '0', optimization of the first code CC<3:0> has not been completed. As the first code increment limit detection signal CILMT is '0', the first code CC<3:0> is in an adjustable state. Because the second code minimum/maximum detection signal FMNX is '1', the second code CF<7:0> is in an unadjustable state. It is assumed that both the first code CC<3:0> and the second code CF<7:0> are '0' at the activation point of the valid section signal DCD-VLD, and that the second duty detection valid signal DCD-OUTN-VLD is generated at a logic high level during an activation section of the valid section signal DCD-VLD.

While the code set selection signal SEL-RECN is at a logic high level, the duty correction operation is performed by adjusting the first code CC<3:0> and the second code CF<7:0> provided to the first duty adjustment circuit 101A.

As the second duty detection valid signal DCD-OUTN-VLD becomes a logic high level, the first code CC<3:0> needs to be decreased. However, because both the first code CC<3:0> and the second code CF<7:0> have already been adjusted to '0', phase adjustment of the first external clock signal RE-C through the first duty adjustment circuit 101A is not possible, and phase adjustment of the second external clock signal RE-N through the second duty adjustment circuit 101B must be performed. Therefore, the code set change signal CHN-SEL transitions to a logic high level, and accordingly, the code set selection signal SEL-RECN transitions to a different logic level than before, for example, a logic low level.

Because the second code minimum/maximum detection signal FMNX is '1', indicating that the second code CF<7:0> is in an unadjustable state, the first change timing signal CCHG-CT is activated first, and then the source clock generation start signal TNCK-STT is activated after a predetermined timing margin.

Although the first change timing signal CCHG-CT and the source clock generation start signal TNCK-STT are activated, the generation of the first adjustment clock signal CCK-EV and the adjustment of the first code CC<3:0> are blocked as the code set change signal CHN-SEL transitions to a logic high level.

The valid section signal DCD-VLD and the second duty detection valid signal DCD-OUTN-VLD are initialized by the reset signal RSTB.

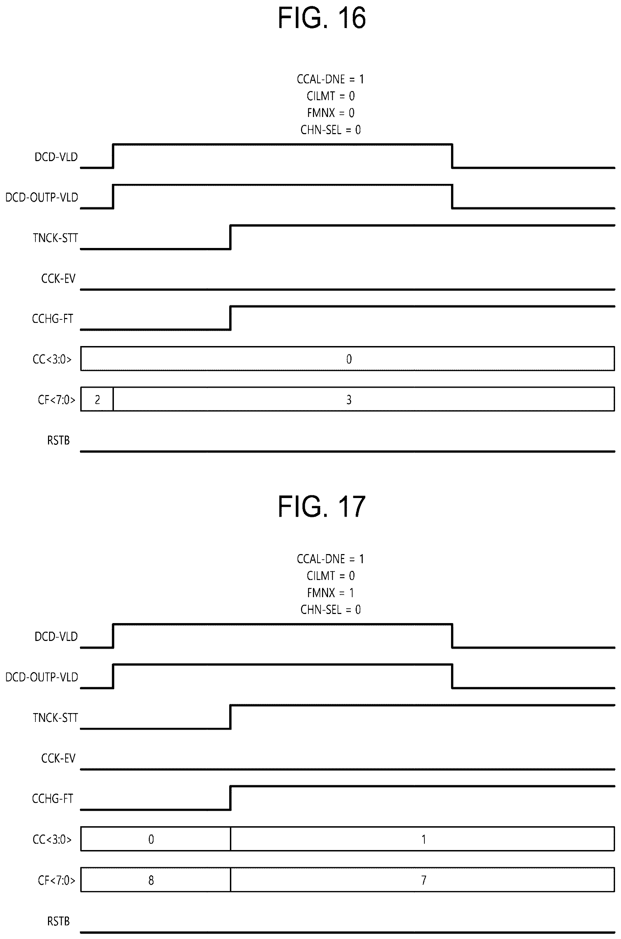

Referring to FIG. 16, the duty cycle correction operation will be described for a case where CCAL-DNE = '1', CILMT = '0', FMNX = '0', and CHN-SEL = '0'.

Because the first code adjustment completion signal CCAL-DNE is '1', the optimal value of the first code CC<3:0> has been found. As the first code increment limit detection signal CILMT and the second code minimum/maximum detection signal FMNX are both '0', both the first code CC<3:0> and the second code CF<7:0> are in adjustable states. It is assumed that the first code CC<3:0> is '0' and the second code CF<7:0> is '2' at the activation point of the valid section signal DCD-VLD, and that the first duty detection valid signal DCD-OUTP-VLD is generated at a logic high level during an activation section of the valid section signal DCD-VLD.

Because the first code adjustment completion signal CCAL-DNE is '1', the second change timing signal CCHG-FT and the source clock generation start signal TNCK-STT may be activated at the same timing.

Although the second change timing signal CCHG-FT and the source clock generation start signal TNCK-STT are activated, the generation of the first adjustment clock signal CCK-EV is blocked because the first code adjustment completion signal CCAL-DNE is '1', and the variation of the first code CC<3:0> is also blocked because the second code minimum/maximum detection signal FMNX is '0'.

Meanwhile, because the first code adjustment completion signal CCAL-DNE is '1', the second code adjustment circuit 404 increases the second code CF<7:0> to '3' according to the first duty detection valid signal DCD-OUTP-VLD at a logic high level.

Referring to FIG. 17, a duty cycle correction operation will be described for a case where CCAL-DNE = '1', CILMT = '0', FMNX = '1', and CHN-SEL = '0'.

Because the first code adjustment completion signal CCAL-DNE is '1', the optimal value of the first code CC<3:0> has been found. As the first code increment limit detection signal CILMT is '0', the first code CC<3:0> is in an adjustable state. However, because the second code minimum/maximum detection signal FMNX is '1', the second code CF<7:0> is in an unadjustable state. It is assumed that the first code CC<3:0> is '0' and the second code CF<7:0> is '8' at the activation point of the valid section signal DCD-VLD, and that the first duty detection valid signal DCD-OUTP-VLD is generated at a logic high level during an activation section of the valid section signal DCD-VLD.

Although the first code adjustment completion signal CCAL-DNE is '1', the second code minimum/maximum detection signal FMNX is also '1', so the second code adjustment circuit 404 maintains the second code CF<7:0> at '8' regardless of the first duty detection valid signal DCD-OUTP-VLD.

Because the first code adjustment completion signal CCAL-DNE is '1', the second change timing signal CCHG-FT and the source clock generation start signal TNCK-STT may be activated at the same timing.

Although the source clock generation start signal TNCK-STT is activated, the generation of the first adjustment clock signal CCK-EV is blocked because the first code adjustment completion signal CCAL-DNE is '1'.

The first code adjustment circuit 403 changes the first code CC<3:0> to '1' according to the second change timing signal CCHG-FT because the second code minimum/maximum detection signal FMNX is '1'.

As the first code CC<3:0> is changed to '1', the second code minimum/maximum detection signal FMNX transitions to '0'.

As the second code minimum/maximum detection signal FMNX transitions to '0', the second code adjustment circuit 404 changes the second code CF<7:0> to '7', so that the duty correction operation can continue.

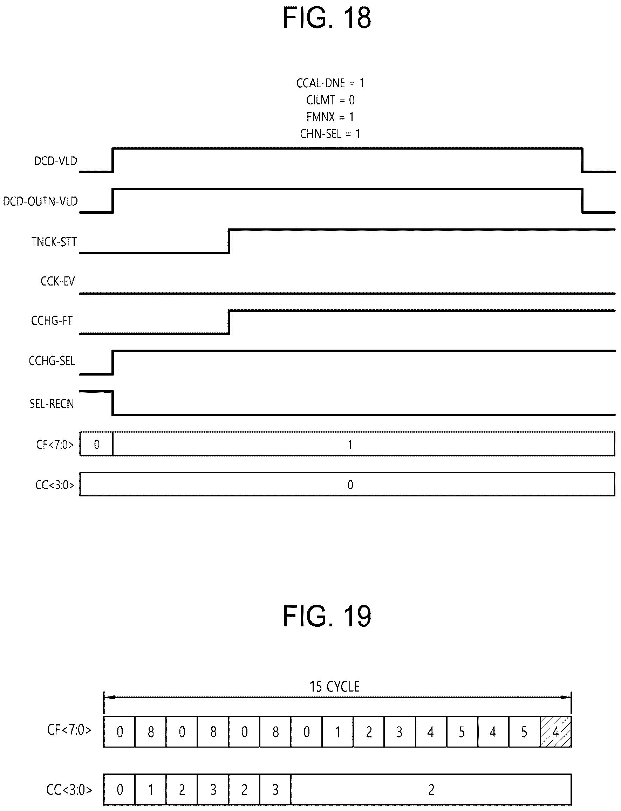

Referring to FIG. 18, the duty cycle correction operation will be described for a case where CCAL-DNE = '1', CILMT = '0', FMNX = '1', and CHN-SEL = '1'.

Because the first code adjustment completion signal CCAL-DNE is '1', an optimal value of the first code CC<3:0> has been found. Although the first code increment limit detection signal CILMT is '0', indicating that the first code CC<3:0> is in an adjustable state, the second code minimum/maximum detection signal FMNX is '1', indicating that the second code CF<7:0> is in an unadjustable state. It is assumed that both the first code CC<3:0> and the second code CF<7:0> are '0' at the activation point of the valid section signal DCD-VLD, and that the first duty detection valid signal DCD-OUTP-VLD is generated at a logic high level during an activation section of the valid section signal DCD-VLD.

Because the code set change signal CHN-SEL is at a logic high level, the generation of the first adjustment clock signal CCK-EV and the variation of the first code CC<3:0> are blocked.

As the code set change signal CHN-SEL transitions to a logic high level, the second code minimum/maximum detection signal FMNX transitions to '0'.

As the second code minimum/maximum detection signal FMNX transitions to '0', the second code adjustment circuit 404 changes the second code CF<7:0> to '1', so that the duty correction operation can continue.

Because the first code adjustment completion signal CCAL-DNE is '1', the second change timing signal CCHG-FT and the source clock generation start signal TNCK-STT may be activated at the same timing.

Although the source clock generation start signal TNCK-STT is activated, the generation of the first adjustment clock signal CCK-EV is blocked because the first code adjustment completion signal CCAL-DNE is '1'.

Although the second change timing signal CCHG-FT is activated, the variation of the first code CC<3:0> is blocked because the code set change signal CHN-SEL is at a logic high level.

FIG. 19 is a diagram illustrating an example of code variation during a duty cycle correction operation according to an embodiment of the present disclosure. FIG. 19 shows an example in which the duty correction is completed by adjusting the first code CC<3:0> to '2' and the second code CF<7:0> to '4'.

Referring to FIG. 19, in each cycle included in the duty correction operation, the second code CF<7:0> is changed by '8', which is the maximum value within an adjustable range, and the first code CC<3:0> is changed by a basic unit. By detecting a bang-bang state of the first code CC<3:0> and the second code CF<7:0> using such a method, the duty cycle correction operation may be completed in 15 cycles. Therefore, compared to the conventional technology described with reference to FIG. 1, the time required for the duty cycle correction operation can be reduced. The above-described embodiment is merely an example in which the second code CF<7:0> is configured with stages from '0' to '8'. When the number of stages of the second code CF<7:0> is increased to improve the resolution of the duty correction operation, the time required for the duty correction operation may be further significantly reduced compared to the conventional technology.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A duty cycle correction circuit comprising:
a duty adjustment circuit configured to adjust phases of a plurality of external clock signals according to a plurality of codes to generate a plurality of duty correction clock signals; and
a duty control circuit configured to control a first correction operation of finding and fixing an optimal value of a first code among the plurality of codes and a second correction operation of finding and fixing an optimal value of a second code among the plurality of codes,
wherein the duty control circuit is configured to, in each of a plurality of cycles during which the first correction operation is performed, change the first code by a basic unit within a first adjustable range and change the second code by a maximum value within a second adjustable range.

2. The duty cycle correction circuit of claim 1, wherein, when the second code is in an adjustable state in a process of performing the first correction operation, the duty control circuit is configured to change the second code by the maximum value within the second adjustable range, and configured to change the first code by the basic unit within the first adjustable range afterward.

3. The duty cycle correction circuit of claim 2, wherein, when the second code is in an unadjustable state in a process of performing the first correction operation, the duty control circuit is configured to change the first code by the basic unit within the first adjustable range, and configured to change the second code by the maximum value within the second adjustable range afterward.

4. The duty cycle correction circuit of claim 1, wherein the duty control circuit is configured to, in each of a plurality of cycles during which the second correction operation is performed, change the second code by a basic unit within the second adjustable range.

5. A duty cycle correction circuit comprising:
a duty adjustment circuit configured to adjust phases of a plurality of external clock signals according to a plurality of codes to generate a plurality of duty correction clock signals;
a duty detection circuit configured to generate a plurality of duty detection signals according to the plurality of duty correction clock signals;
a code adjustment clock generation circuit configured to generate a plurality of code adjustment clock signals for varying a second code among the plurality of codes by a maximum value within an adjustable range for each of a plurality of cycles in a first section, the first section including a time frame from a time at which adjustment of a first code among the plurality of codes starts to a time at which the adjustment of the first code is completed to activate a first code adjustment completion signal;
a multiplexer configured to selectively output the plurality of code adjustment clock signals and a plurality of duty detection valid signals according to the first code adjustment completion signal;
a first code adjustment circuit configured to vary the first code according to the plurality of duty detection valid signals, and configured to generate a first code minimum detection signal and a first code maximum detection signal according to the first code; and
a second code adjustment circuit configured to vary the second code according to an output of the multiplexer.

6. The duty cycle correction circuit of claim 5, further comprising a completion determination circuit configured to detect a bang-bang state of the first code according to the plurality of duty detection signals, and configured to activate the first code adjustment completion signal.

7. The duty cycle correction circuit of claim 5,
wherein the plurality of duty detection signals corresponding to a valid section signal are output as the plurality of duty detection valid signals, and
wherein the duty cycle correction circuit further comprises a code value determination circuit configured to generate a first code increment limit detection signal, a second code minimum/maximum detection signal, and a code set change signal according to the first code minimum detection signal, the first code maximum detection signal, the plurality of duty detection valid signals, and at least one of a most significant bit and a least significant bit of each of the plurality of codes.

8. The duty cycle correction circuit of claim 7, wherein the code value determination circuit is configured to activate the code set change signal when the first code and the second code are at a minimum stage and a second duty detection valid signal among the plurality of duty detection valid signals is at a first logic level.

9. The duty cycle correction circuit of claim 7, wherein the code value determination circuit is configured to activate the first code increment limit detection signal when the first code is at a maximum stage and a first duty detection valid signal among the plurality of duty detection valid signals is at a first logic level.

10. The duty cycle correction circuit of claim 7, wherein the code value determination circuit is configured to activate the second code minimum/maximum detection signal in at least one of following cases:
a) when a least significant bit of the first code is at a second logic level and the second code is at a minimum stage and a second duty detection valid signal among the plurality of duty detection valid signals is at a first logic level,
b) when the least significant bit is at the second logic level and the second code is at a maximum stage and the second duty detection valid signal is at the first logic level,
c) when the least significant bit is at the second logic level and the second code is at the maximum stage and a first duty detection valid signal among the plurality of duty detection valid signals is at the first logic level, and
d) when the least significant bit is at the first logic level and the second code is at the minimum stage and the first duty detection valid signal is at the first logic level.

11. The duty cycle correction circuit of claim 7, wherein the code adjustment clock generation circuit is configured to block generation of the plurality of code adjustment clock signals when any one of the first code increment limit detection signal, the code set change signal, and the first code adjustment completion signal is activated.

12. The duty cycle correction circuit of claim 5, wherein the multiplexer is configured to output the plurality of code adjustment clock signals when the first code adjustment completion signal is in an inactive state, and configured to output the plurality of duty detection valid signals when the first code adjustment completion signal is in an active state.

13. The duty cycle correction circuit of claim 7, wherein the first code adjustment circuit is configured to block variation of the first code when the second code minimum/maximum detection signal is in an inactive state.

14. The duty cycle correction circuit of claim 7, wherein the first code adjustment circuit is configured to block variation of the first code when the code set change signal is activated.

15. The duty cycle correction circuit of at least one of claim 1 and claim 5, wherein the duty adjustment circuit comprises:
a first duty adjustment circuit configured to adjust a phase of a first external clock signal among the plurality of external clock signals according to the first code and the second code to generate a first duty correction clock signal among the plurality of duty correction clock signals; and
a second duty adjustment circuit configured to adjust a phase of a second external clock signal among the plurality of external clock signals according to a third code and a fourth code among the plurality of codes to generate a second duty correction clock signal among the plurality of duty correction clock signals.

16. The duty cycle correction circuit of claim 15, wherein the first duty adjustment circuit comprises:
a first adjustment circuit configured to delay the first external clock signal by a time corresponding to the first code to generate a first clock signal and a second clock signal; and
a second adjustment circuit configured to mix the first clock signal and the second clock signal at a predetermined ratio according to the second code to generate the first duty correction clock signal.

17. The duty cycle correction circuit of claim 15, further comprising a phase divider circuit configured to generate multi-phase clock signals by divide phases of the first duty correction clock signal and the second duty correction clock signal.

18. The duty cycle correction circuit of claim 17, further comprising a duty detection circuit configured to detect phase differences of the multi-phase clock signals to generate a plurality of duty detection signals, and configured to provide the plurality of duty detection signals to the duty control circuit.

19. The duty cycle correction circuit of claim 15,
wherein, the first code adjustment circuit is configured to vary the first code and the second code when the first duty adjustment circuit is selected,
wherein, the second code adjustment circuit is configured to vary the third code and the fourth code when the second duty adjustment circuit is selected.

20. The duty cycle correction circuit of claim 5, wherein the code adjustment clock generation circuit comprises:
a source clock generation circuit configured to divide one of the plurality of external clock signals to generate a plurality of divided clock signals, and configured to output, as a source clock signal, pulses corresponding to a section determined by a plurality of adjustment clock section signals among pulses of the plurality of divided clock signals;
a shifting circuit configured to shift a first logic level according to the plurality of divided clock signals to generate the plurality of adjustment clock section signals; and
an adjustment clock generation circuit configured to generate the plurality of code adjustment clock signals according to the source clock signal, configured to select one of the plurality of code adjustment clock signals based on a least significant bit of the first code and one of the plurality of duty detection valid signals, and configured to output the selected one of the plurality of code adjustment clock signals while blocking an output of remaining of the plurality of code adjustment clock signals.

21. The duty cycle correction circuit of claim 7, wherein the completion determination circuit further comprises:
a counter configured to count the valid section signal to generate a count result signal;
a bang-bang detection circuit configured to generate a bang-bang detection signal according to a bang-bang reset signal and the plurality of duty detection signals;
a first signal generation circuit configured to activate the first code adjustment completion signal when any one of the bang-bang detection signal, the first code adjustment completion signal, and the first code increment limit detection signal is activated after deactivation of the valid section signal; and
a second signal generation circuit configured to generate the bang-bang reset signal according to activation of the first code adjustment completion signal.
